# EUROPEAN PATENT APPLICATION

(11) **EP 4 597 120 A1**
(43) Date of publication of application: **06.08.2025**
(21) Application number: 25152853.5
(22) Date of filing: 20.01.2025
(51) Int. Cl.: G01P 15/125, G01P 15/08

(54) **MEMS SENSOR HAVING A HIGH ROBUSTNESS AGAINST THE STICTION PHENOMENON**

(30) Priority: 01.02.2024 IT 202400002115
(71) Applicant: STMicroelectronics International N.V., 1228 Plan-les-Ouates, Geneva (CH)
(72) Inventor: RIZZINI, Francesco, 25050 Passirano (BS) (IT); GATTERE, Gabriele, 21040 Castronno (VA) (IT)
(74) Representative: Studio Torta S.p.A.

(57) **Abstract**

A MEMS sensor (1) is configured to measure a physical quantity and has a substrate (10) and a movable mass (12) suspended at a distance from the substrate along a direction (Z), wherein the movable mass is coupled to the substrate so as to undergo a movement (M) along a sensing direction (S), with respect to the substrate, as a function of the physical quantity to be measured. The MEMS sensor also has a contact sensing structure (30) coupled to the substrate and which extends, at rest, at a distance (gsw) from the movable mass along the sensing direction; and at least one stator electrode (18A, 18B) coupled to the substrate and configured to form with the movable mass at least one capacitor having a capacitance variable as a function of the movement of the movable mass. A control circuit (5) is configured to: induce a voltage difference between the movable mass and the stator electrode, for sensing a capacitance variation between the movable mass and the stator electrode; sense a contact between movable mass and contact sensing structure; and in response to sensing the contact between movable mass and contact sensing structure, modify the induced voltage difference, so as to reduce an electrostatic force exerted by the at least one stator electrode on the movable mass.

## Description

### Technical Field

The present invention relates to a MEMS ("Micro ElectroMechanical Systems") sensor having a high robustness against the stiction phenomenon. In particular, the invention refers to an inertial sensor such as an accelerometer.

### Background

As is known, the stiction phenomenon may cause the malfunction of MEMS sensors based on the movement of a movable mass.

For example, MEMS accelerometers of known type have a movable mass suspended over a substrate and free to move with respect to the substrate, depending on an external acceleration. The movable mass is coupled to the substrate through coupling elastic elements.

It is equally known to provide MEMS accelerometers with end-of-stroke mechanical elements (stoppers), fixed to the substrate and arranged, at rest, at a distance from the movable mass. The stoppers determine the maximum displacement to which the movable mass may be subject, in use.

In the presence of high acceleration, the movable mass may undergo a large displacement, such as to cause contact between the movable mass and the stoppers. In response to the contact between the movable mass and the stoppers, an attractive adhesion force may establish between the movable mass and the stoppers.

When the high acceleration ends, if the adhesion force cannot be exceeded by the return force exerted by the coupling elastic elements, the movable mass does not return to the rest position. In other words, in this case, the movable mass is subject to the stiction phenomenon and remains stuck. As a result, the movable mass is no longer capable of moving depending on the external acceleration, causing sensing malfunctions of the accelerometer.

According to one approach, the coupling elastic elements are designed to have high stiffness. In this manner, the coupling elastic elements exert a high elastic return force, thus decreasing the risk of stiction phenomenon. However, this approach may cause higher sensing noise and lower sensor stability.

According to another approach, the stoppers may have an anti-stiction layer configured to reduce the adhesion force that may establish between the movable mass and the stoppers. However, this approach entails higher manufacturing complexity, additional manufacturing steps and, therefore, high manufacturing costs.

According to a further approach, the sensor may have dedicated electrodes configured to exert an electrostatic force on the movable mass, in the opposite direction to that of the adhesion force. However, the Applicant has observed that the electrostatic force necessary to detach the movable mass from the stoppers may cause a movement of the movable mass such as to cause the movable mass to bump with further stoppers arranged on an opposite side of the movable mass, causing a further stiction condition. In practice, this approach is also not effective in taking the sensor back to a working operational state.

The aim of the present invention is to overcome, at least in part, the disadvantages of the prior art.

### Summary

According to the present invention, a MEMS sensor and a method for controlling a MEMS sensor are therefore provided, as defined in the attached claims.

### Brief Description of the Drawings

For a better understanding of the present invention, embodiments thereof are now described, purely by way of nonlimiting example, with reference to the attached drawings, wherein:
- Figure 1 shows a schematic view of a MEMS accelerometer, according to one embodiment;
- Figure 2 shows a portion of the MEMS accelerometer of Figure 1, in a first condition of use;
- Figure 3 shows the portion of the MEMS accelerometer of Figure 2, in a second condition of use;
- Figure 4 shows the portion of the MEMS accelerometer of Figure 2, in a third condition of use;
- Figure 5 shows a schematic cross-section of a MEMS accelerometer, at rest, according to a different embodiment; and
- Figure 6 shows the MEMS accelerometer of Figure 5, in use.

### Description of Embodiments

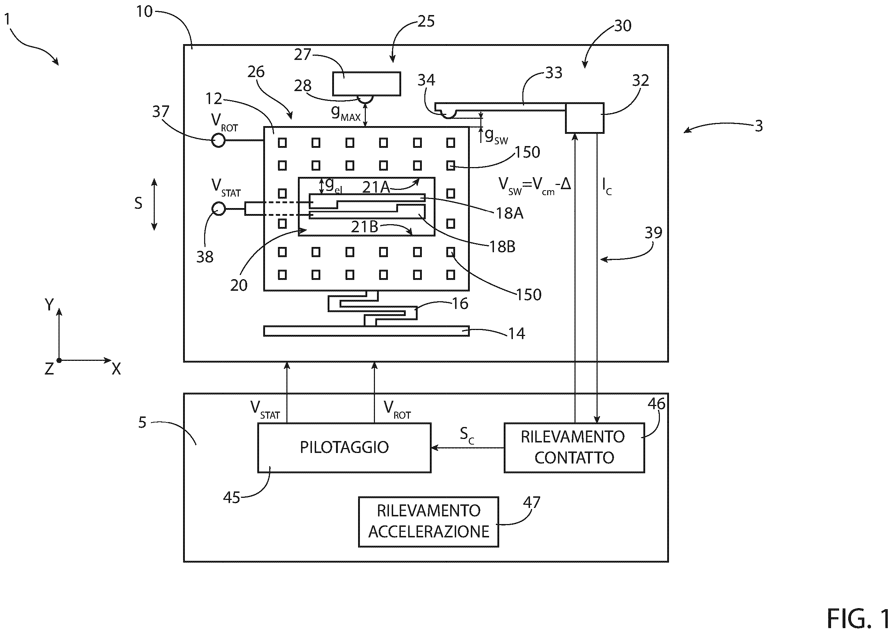

Figure 1 shows a MEMS sensor, in particular a MEMS accelerometer 1, comprising a sensing body 3 and a control circuit 5.

The sensing body 3 will be described hereinbelow with reference to a Cartesian reference system XYZ having a first axis X, a second axis Y and a third axis Z.

The MEMS accelerometer 1 may be formed by using micro/nano processing techniques starting from one or more bodies of semiconductor material, for example silicon.

For example, the sensing body 3 and the control circuit 5 may be formed in a same die or in distinct dice.

The MEMS accelerometer 1 comprises a substrate 10 and a movable mass 12 suspended on the substrate 10. The movable mass 12 extends at a distance from the substrate 10 along the third axis Z.

The movable mass 12 may be, as a whole or in part, of semiconductor material, for example silicon or polysilicon, suitably doped.

The movable mass 12 is coupled to the substrate 10 so as to undergo an in-plane movement along a sensing direction S (here parallel to the second axis Y) with respect to the substrate 10, in response to an external acceleration undergone by the MEMS accelerometer 1.

In particular, in this embodiment, the movable mass 12 is configured to undergo a movement along the sensing direction S, in response to an acceleration along the sensing direction S.

In detail, the MEMS accelerometer 10 comprises an anchoring region 14 fixed to the substrate 10, and a coupling elastic element (spring) 16 which extends between the anchoring region 14 and the movable mass 12. The coupling elastic element 16 maintains the movable mass 12 suspended on the substrate 10.

The anchoring region 14 and/or the coupling elastic element 16 may be, as a whole or in part, of semiconductor material, for example silicon or polysilicon, suitably doped.

The coupling elastic element 16 is configured to allow a movement of the movable mass 12 parallel to the sensing direction S, with respect to the substrate 10. In particular, the coupling elastic element 16 is configured to cause a movement of the movable mass 12 along the sensing direction S, in response to an acceleration of the MEMS accelerometer 1 along the sensing direction S.

The MEMS accelerometer 10 comprises two stator electrodes 18A, 18B mechanically coupled to the substrate 10 and arranged at a distance from the movable mass 12 along the sensing direction S.

The stator electrodes 18A, 18B are carried by the substrate 10, in particular fixed to the substrate 10.

The stator electrodes 18A, 18B are capacitively coupled to the movable mass 12. For example, the stator electrodes 18A, 18B may be of semiconductor material, for example silicon or polysilicon, suitably doped.

In this embodiment, the movable mass 12 has a through cavity 20 that extends through the movable mass 12, throughout the thickness of the movable mass 12 along the third axis Z. The stator electrodes 18A, 18B are arranged inside the through cavity 20.

In detail, the movable mass 12 has a first internal wall 21A which delimits the through cavity 20 on a first side, and a second internal wall 21B which delimits the through cavity 20 on a second side opposite to the first side along the sensing direction S.

The stator electrode 18A faces the first internal wall 21A. The stator electrode 18B faces the second internal wall 21B.

The first and the second internal walls 21A, 21B form rotor electrodes integral with the movable mass 12 and each capacitively coupled to the respective stator electrode 18A, 18B. In other words, the movable mass 12 comprises the rotor electrodes 21A, 21B.

In practice, the internal walls 21A, 21B and the stator electrodes 18A, 18B form respective capacitors having variable capacitance depending on the movement of the movable mass 12.

The stator electrodes 18A, 18B each extend at a distance gₑₗ, along the sensing direction S, from the respective internal wall 21A, 21B.

The distance gₑₗ may be comprised, for example, between 2 µm and 3 µm.

In this embodiment, the stator electrodes 18A, 18B are at the same distance gₑₗ from the respective internal wall 21A, 21B. However, the stator electrodes 18A, 18B may extend, from the respective internal wall 21A, 21B, at different distances one from the other.

The sensing body 3 also comprises a stroke-end region (stopper) 25 extending, at rest, at a distance gₘₐₓ from the movable mass 12 along the sensing direction S.

The stopper region 25 is configured to determine a maximum movement to which the movable mass 12 may be subject parallel to the sensing direction S.

The stopper region 25 may be, as a whole or in part, of semiconductor material, for example silicon or polysilicon, suitably doped.

The distance gₘₐₓ may be comprised, for example, between 1.5 µm and 2.8 µm.

The distance gₘₐₓ may be shorter than the distance gₑₗ.

In this manner, the stopper region 25 may prevent the movable mass 12, in use, from bumping against the stator electrodes 18A, 18B. In other words, the maximum movement to which the movable mass 12 may be subject is smaller than the movement along the sensing direction S which would put the movable mass 12 into contact with the stator electrodes 18A, 18B.

In particular, in this embodiment, the stopper region 25 extends, at rest, at a distance from an external wall 26 of the movable mass 12.

The stopper region 25 is carried by the substrate 10 and may be integrally coupled (fixed) to the substrate 10.

In detail, the stopper region 25 comprises an anchoring region 27 fixed to the substrate 10 and a protruding region 28 which extends from the anchoring region 27 towards the external wall 26 of the movable mass 12.

The protruding region 28 extends at the distance gₘₐₓ from the external wall 26 of the movable mass 12.

The sensing body 3 further comprises a contact sensing structure 30 mechanically coupled to the substrate 10 and extending, at rest, at a distance gsw from the movable mass 12 along the sensing direction S.

In practice, the contact sensing structure 30 is carried by the substrate 10.

The contact sensing structure 30 may be, as a whole or in part, of semiconductor material, for example silicon or polysilicon, suitably doped.

The distance gsw may be comprised, for example, between 1.2 µm and 2.5 µm.

The distance gsw may be shorter than the distance gₘₐₓ. In this manner, in use, the movable mass 12, during a movement along the sensing direction S, may touch the contact sensing structure 30 before the stopper region 25.

In particular, in this embodiment, the contact sensing structure 30 extends, at rest, at the distance gsw from the external wall 26 of the movable mass 12.

In detail, the contact sensing structure 30 comprises an anchoring region 32 fixed to the substrate 10, a deformable region 33 which extends from the anchoring region 32, and a bumper portion 34 configured to touch the movable mass 12, during a movement of the movable mass 12 along the sensing direction S.

The deformable region 33 is further configured to undergo an elastic deformation in response to a bump of the movable mass 12 with the contact sensing structure 30.

In this embodiment, the deformable region 33 has main extension transversal to the sensing direction S, in particular here parallel to the first axis X.

For example, the deformable region 33 may be suspended on the substrate 10, at a distance therefrom along the third axis Z. For example, the deformable region 33 may be a cantilever.

The deformable region 33 partly faces the movable mass 12 along the sensing direction S; in particular, faces the external wall 26.

In the embodiment of Figure 1, the bumper portion 34 faces the movable mass 12 along the sensing direction S and extends from the deformable region 33 towards the movable mass 12 along the sensing direction S.

The bumper portion 34 determines the distance gsw.

The bumper portion 34 has a contact surface that is configured to come into contact with the movable mass 12 in response to a movement of the movable mass 12 along the sensing direction S (upwards in Figure 1). The contact surface may be small with respect to the surface of the external wall 26; this may allow the adhesion force, that might establish between the movable mass 12 and the bumper portion 34, to be reduced. For example, the contact surface of the bumper portion 34 may have an in-plane extension (e.g., in the plane XY) comprised between 0.2 µm and 10 µm. For example, the contact surface of the bumper portion 34 may extend along the third axis Z throughout the thickness of the movable mass 12.

The MEMS accelerometer 1 further comprises means for the electrical connection of the sensing body 3 with the control circuit 5, such as for example conductive tracks, contact pads, etc., shown only schematically in Figure 1.

In detail, the MEMS accelerometer 1 comprises connection means 37 for the electrical connection of the movable mass 12; connection means 38 for the electrical connection of the stator electrodes 18A, 18B; and connection means 39 for the electrical connection of the contact sensing structure 30.

In particular, the movable mass 12 may have an electrical behavior of a conductive/metal type, for example if it is of suitably doped semiconductor material; therefore, hereinafter, for simplicity, electrical connection of the movable mass 12 means electrical connection also of the internal walls (rotor electrodes) 21A, 21B and of the external wall 26 or, more generally, of the entire movable mass 12 as a whole. In practice, hereinafter, it may be assumed for simplicity that movable mass 12, rotor electrodes 21A, 21B and external wall 26 are substantially at the same electrical potential.

Similarly, the contact sensing structure 30 may also have an electrical behavior of a conductive/metal type, for example if it is of suitably doped semiconductor material; therefore, hereinafter, for simplicity, electrical connection of the contact sensing structure 30 means electrical connection of the bumper portion 34 or, more generally, of the entire contact sensing structure 30.

The control circuit 5 comprises a driving (biasing) circuitry 45 electrically coupled to the movable mass 12 and to the stator electrodes 18A, 18B; and a contact sensing circuitry 46 electrically coupled to the contact sensing structure 30.

The driving circuitry 45 is configured to bias the movable mass 12 and/or the stator electrodes 18A, 18B, so as to be capable of sensing capacitance variations between the movable mass 12 and the stator electrodes 18A, 18B, in response to a movement of the movable mass 12. In other words, the driving circuitry 45 is configured to induce a voltage difference between the movable mass 12 and the stator electrodes 18A, 18B, for sensing a capacitance variation between movable mass 12 and stator electrodes 18A, 18B.

The contact sensing circuitry 46 is configured to sense a contact between the movable mass 12 and the bumper portion 34 of the contact sensing structure 30.

The control circuit 5 further comprises an acceleration sensing circuitry 47 coupled, in a manner not shown here, to the sensing body 3 and to one or more of the driving circuitry 45 and the contact sensing circuitry 46, and configured to sense an external acceleration in a manner per se known and therefore not further discussed in detail herein. For example, the acceleration sensing circuitry 47 may be configured to measure capacitance variations between rotor (movable mass 12) and stator (electrodes 18A, 18B).

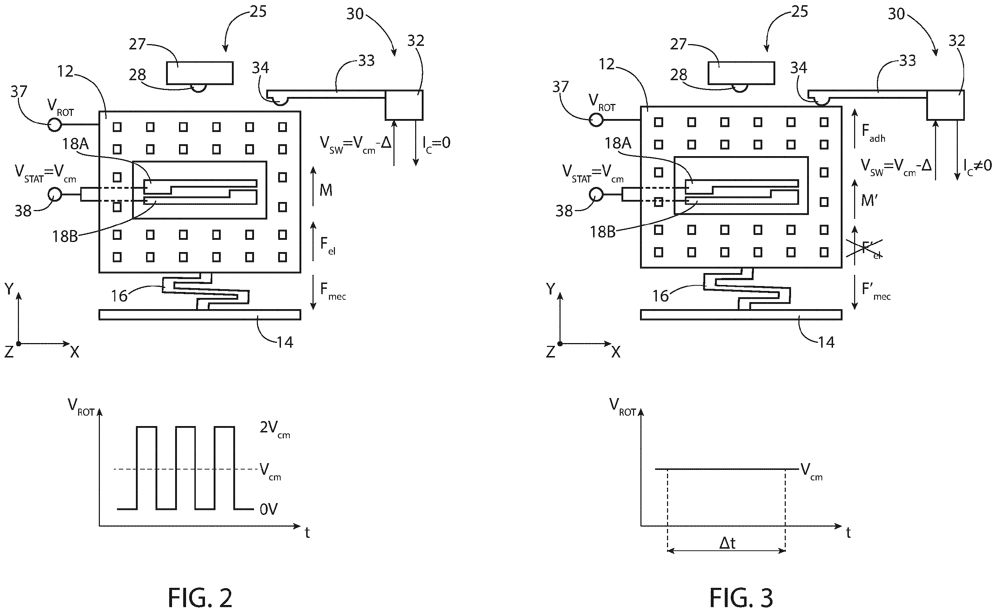

Figure 2 shows the MEMS accelerometer 1, in use, in a normal operating condition wherein the MEMS accelerometer 1 has undergone a low external acceleration, for example lower than a maximum acceleration value aₘₐₓ detectable by the MEMS accelerometer 1. For example, in the normal operating condition of Figure 2, the external acceleration may be zero or may be such as to cause, along the sensing direction S, a movement M of the movable mass 12, with respect to the rest position of Figure 1, smaller than the distance gsw.

Purely by way of example, in Figure 2, the movement M of the movable mass 12 is upwards, i.e. moving towards the bumper portion 34 of the contact sensing structure 30.

In the normal operating condition, to sense the external accelerations undergone by the MEMS accelerometer 1, the driving circuitry 45 biases the movable mass 12 and the stator electrodes 18A, 18B. In other words, the driving circuitry 45 induces a voltage difference between the movable mass 12 and the stator electrodes 18A, 18B. In this manner the capacitance variations between rotor electrodes 21A, 21B and stator electrodes 18A, 18B caused by the movement of the movable mass 12 in response to the acceleration of the MEMS accelerometer 1 may be sensed.

In detail, the driving circuitry 45 applies a rotor voltage V_{ROT} to the rotor electrodes 21A, 21B and a stator voltage V_{STAT} different from the rotor voltage V_{ROT} to the stator electrodes 18A, 18B.

In this embodiment, the stator voltage V_{STAT} is a DC voltage equal to V_{cm} and the rotor voltage V_{ROT} is a time-varying voltage.

In detail, the rotor voltage V_{ROT} may oscillate between a minimum value and a maximum value, for example with a constant or variable frequency.

The voltage V_{ROT} may be a varying voltage around the stator voltage V_{STAT}=V_{cm}.

In particular, the rotor voltage V_{ROT} may have an average value over time equal to the stator voltage V_{STAT}.

In the example of Figure 2, the rotor voltage V_{ROT} is a square wave comprised between 0 V and 2·V_{CM}.

The movement M of the movable mass 12 moves the internal wall 21B towards the stator electrode 18B and moves the internal wall 21A away from the stator electrode 18A, with respect to the rest position of Figure 1. The resulting capacitance variation may be sensed by the acceleration sensing circuitry 47.

In practice, in response to the movement M of the movable mass 12, the distance along the sensing direction S between the movable mass 12 and the stator electrode 18B is shorter with respect to the distance between the movable mass 12 and the stator electrode 18A. Consequently, a net electrostatic force Fₑₗ (upwards in the example of Figure 2) is exerted on the movable mass 12.

At the same time, the coupling elastic element 16 undergoes a deformation (an elongation in the example of Figure 2) in response to the movement M of the movable mass 12 of Figure 2. Therefore, in response to the movement M of the movable mass 12, the coupling elastic element 16 exerts an elastic return force F_{mec} on the movable mass 12, along the sensing direction S and in an opposite direction to the net electrostatic force Fₑₗ (i.e., downwards in the example of Figure 2).

In the normal operating condition, the MEMS accelerometer 1 is configured in such a way that, when the external acceleration ends, the elastic return force F_{mec} takes the movable mass 12 back to the equilibrium position of Figure 1.

During normal operating condition, the contact sensing circuitry 46 induces a voltage difference between the contact sensing structure 30 and the movable mass 12.

In detail, in this embodiment, the contact sensing circuitry 46 applies a direct voltage V_{SW} to the contact sensing structure 30. The direct voltage V_{SW} may be different from the average value of the rotor voltage V_{ROT}; in particular, it may be a lower voltage.

In particular, in the embodiment of Figure 2, V_{SW} = V_{cm} - Δ.

The contact sensing circuitry 46 is further configured to sense a contact current I_{C} between the movable mass 12 and the contact sensing structure 30.

In particular, the contact sensing circuitry 46 may be configured to sense a DC component of the contact current Ic.

During the normal operating condition, wherein the movable mass 12 undergoes movements such as to remain at a distance from the contact sensing structure 30, the contact current I_{C} is zero.

Figure 3 shows the MEMS accelerometer 1, in use, in a first shock operating condition wherein the MEMS accelerometer 1 has undergone a high external acceleration, for example equal to or greater than the maximum acceleration value aₘₐₓ detectable by the MEMS accelerometer 1. For example, in the operating condition of Figure 3, the external acceleration is such as to cause, along the sensing direction S, a movement M' of the movable mass 12, with respect to the rest position of Figure 1, equal to or greater than the distance gsw.

In practice, the movement M' of the movable mass 12 is such as to cause a contact of the movable mass 12 with the bumper portion 34 of the contact sensing structure 30.

In response to the contact of the movable mass 12 with the bumper portion 34, the contact sensing circuitry 46 senses a contact current I_{C} different from zero. In fact, in response to the contact, the contact current I_{C} is a function of the voltage difference between the rotor voltage V_{ROT} and the voltage V_{SW}.

For example, the contact sensing circuitry 46 may be configured to sense when the contact current I_{C} exceeds a threshold value, equal to or different from zero, which may be chosen during a design or calibration step.

In response to sensing the contact current I_{C} different from zero, the contact sensing circuitry 46 generates a contact sensing signal Sc.

The driving circuitry 45 receives the contact sensing signal S_{C} and, in response, modifies the bias of the stator electrodes 18A, 18B and/or the movable mass 12 described with reference to Figure 2, so as to reduce the electrostatic force exerted by the stator electrodes 18A, 18B on the movable mass 12.

In other words, the driving circuitry 45 may modify the voltage difference induced between stator electrodes 18A, 18B and movable mass 12, for sensing capacitance variations.

For example, the driving circuitry 45 may reduce the amplitude of the rotor voltage V_{ROT}.

In this embodiment, the driving circuitry 45, in response to receiving the contact sensing signal Sc, applies a rotor voltage V_{ROT} that is a DC voltage equal to the stator voltage V_{STAT}=V_{cm}.

The driving circuitry 45 may maintain the rotor voltage V_{ROT} at the new value (here maintain V_{ROT}=V_{cm}) for a time interval Δt greater than 5 ms, for example comprised between 5 ms and 30 ms, in particular of about 10 ms; this may contribute to lowering the risk of stiction of the movable mass to the bumper portion 34.

At the end of the time interval Δt, the MEMS accelerometer 1 may return to the normal operating condition, described above with reference to Figure 2, for sensing new external accelerations undergone by the MEMS accelerometer 1.

In response to the contact of the movable mass 12 with the bumper portion 34, the bumper portion 34 might exert an adhesion force F_{adh} along the sensing direction S (upwards in the example of Figure 3) on the movable mass 12.

At the same time, the coupling elastic element 16 undergoes a deformation (an elongation in the example of Figure 3) in response to the movement M'. Therefore, the coupling elastic element 16 exerts an elastic return force F'_{mec} on the movable mass 12, along the sensing direction S and in the opposite direction to the adhesion force.

Reducing the potential difference between movable mass 12 and stator electrodes 18A, 18B causes the stator electrodes 18A, 18B to apply a low net electrostatic force F'ₑₗ on the movable mass 12; i.e., lower than that which would be applied in the operating condition of Figure 2 (i.e. if the rotor voltage V_{ROT} remained that described in reference to Figure 2).

By lowering the electrostatic force contribution introduced by the stator electrodes 18A, 18B on the movable mass 12, the risk that the movable mass 12 remains stuck on the bumper portion 34 may be reduced. The MEMS accelerometer 1 may therefore have a high robustness against the stiction phenomenon.

In particular, in the embodiment shown, the voltage difference between movable mass 12 and stator electrodes 18A, 18B is zeroed (V_{ROT}=V_{STAT}=V_{cm}). Consequently, the electrostatic contribution F'ₑₗ, which would be applied on the movable mass 12 by the stator electrodes 18A, 18B is also zeroed. This allows the robustness of the MEMS accelerometer 1 against the stiction phenomenon to be further increased.

The present MEMS accelerometer may therefore have a high reliability.

The potential difference between the movable mass 12 and the contact sensing structure 30 may cause an electrostatic force contribution along the sensing direction S and opposite to the elastic return force (i.e., upwards in Figures 2 and 3).

However, the fact that the bumper portion 34 may have a low contact area with the movable mass 12 contributes to reducing the risk of stiction of the movable mass 12 to the bumper portion 34.

Additionally or alternatively, the fact that the voltage difference between V_{SW} and V_{ROT} is low contributes to reducing this electrostatic contribution.

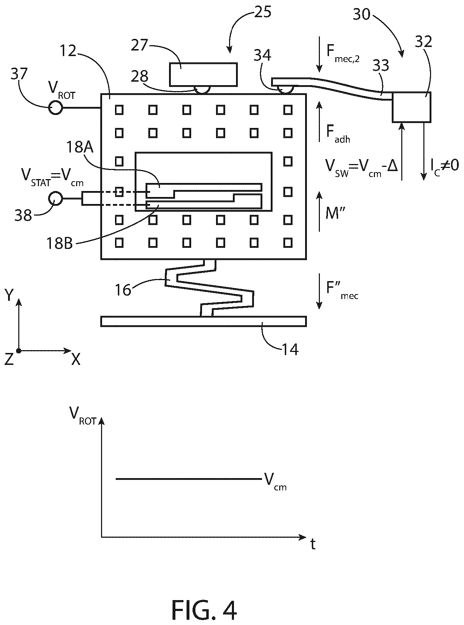

Figure 4 shows the MEMS accelerometer 1, in use, in a second shock operating condition wherein the MEMS accelerometer 1 has undergone a high external acceleration, for example equal to or greater than the maximum acceleration value aₘₐₓ detectable by the MEMS accelerometer 1.

In detail, in the operating condition of Figure 4, the external acceleration is such as to cause, along the sensing direction S, a movement M" of the movable mass 12, with respect to the rest position of Figure 1, greater than the distance gsw.

In practice, the movement M" of the movable mass 12 is such as to cause a contact of the movable mass 12 with the bumper portion 34 of the contact sensing structure 30 and a deformation of the deformable region 33 of the contact sensing structure 30.

In particular, in Figure 4, the movement M" of the movable mass 12 is such as to put the movable mass 12 into contact with the stopper region 25.

What has been described in reference to Figure 3 in response to the contact of the movable mass 12 with the bumper portion 34 also applies to the operating condition of Figure 4.

In addition, the fact that the deformable region 33 deforms along the sensing direction S in response to the bump with the movable mass 12 causes the deformable region 33 to exert a respective elastic return force F_{mec,2}, on the movable mass 12, parallel to the sensing direction S, along the same direction as the elastic return force F''_{mec} of the coupling elastic element 16. Therefore, the deformable region 33 provides a further force contribution in the opposite direction to that of the adhesion force.

In other words, the fact that the contact sensing structure 30 is deformable in response to the contact with the movable mass 12 may contribute to further increasing the robustness of the MEMS accelerometer 1 against the stiction phenomenon, thus increasing its sensing reliability.

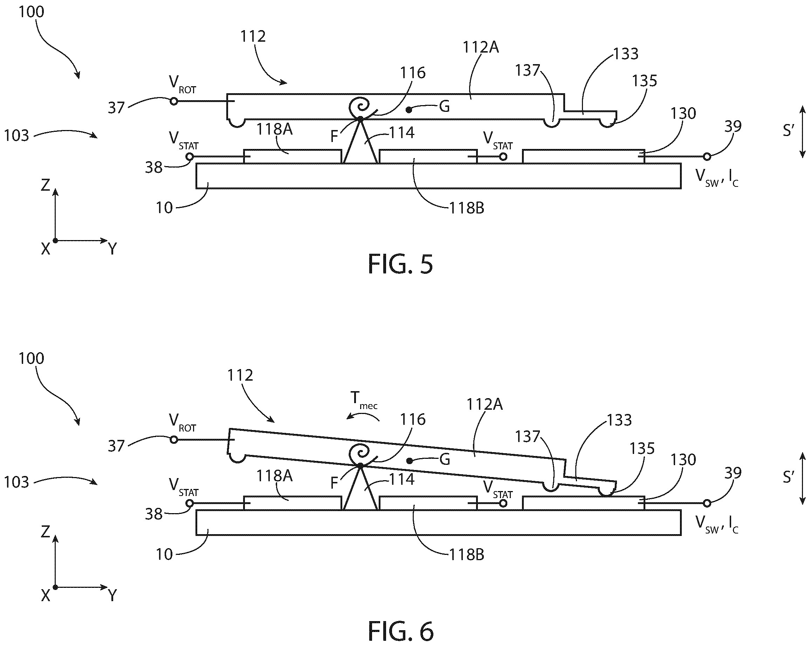

Figure 5 shows a different embodiment of the MEMS accelerometer 100, at rest, in the Cartesian reference system XYZ. Only the respective sensing body 103 of the MEMS accelerometer 100 is shown, limitedly to the parts useful for understanding the present invention.

The MEMS accelerometer 100 also comprises the control circuit 5 of Figure 1, not shown here in detail.

The MEMS accelerometer 100 is an out-of-plane MEMS accelerometer, configured to sense an acceleration along an out-of-plane sensing direction S', parallel to the third axis Z.

The MEMS accelerometer 100 comprises the substrate 10 and a movable mass 112 suspended on the substrate 10. The movable mass 112 extends at a distance from the substrate along the third axis Z.

In this embodiment, the movable mass 112 is coupled to the substrate 10 in such a way as to undergo an out-of-plane movement (i.e. having a component along the third axis Z) with respect to the substrate 10, in response to an external acceleration of the MEMS accelerometer 100 along the third axis Z.

The MEMS accelerometer 100 comprises an anchoring region 114 fixed to the substrate 10 and at least one coupling elastic element 116 (represented only schematically in Figure 5) which couples the movable mass 112 to the anchoring region 114. The coupling elastic element 116 maintains, at rest, the movable mass 112 suspended on the substrate 10.

The coupling elastic element 116 is configured to allow the out-of-plane movement of the movable mass 112, in response to an acceleration along the third axis Z undergone by the MEMS accelerometer 100.

In detail, in this embodiment, the MEMS accelerometer 100 has a teeter-totter structure.

In practice, the movable mass 112 has a barycenter G and the coupling elastic element 116 couples the movable mass 112 to the anchoring region 114 at a point of fulcrum F having an offset with respect to the barycenter G of the movable mass 112.

The coupling elastic element 116 is a torsional elastic element configured to allow a rotation of the movable mass 112 around a rotation axis (not shown here) passing through the point of fulcrum F and parallel to the first axis X.

In other words, the rotation axis is a non-barycentric axis, i.e. it does not pass through the barycenter G of the movable mass 112.

The MEMS accelerometer 100 comprises stator electrodes 118A, 118B fixed to the substrate 10 and arranged at a distance, along the third axis Z, from the movable mass 112.

The stator electrodes 118A, 118B are capacitively coupled to the movable mass 112, which therefore forms rotor electrodes, similarly to what has been described for the MEMS accelerometer 1 of Figure 1.

The MEMS accelerometer 100 also comprises a contact sensing structure 130, fixed to the substrate 10 and configured, in response to a high acceleration (shock) of the MEMS accelerometer 100, to come into contact with the movable mass 112 before the movable mass 112 comes into contact with the stator electrodes 118A, 118B.

In detail, to ensure that the movable mass 112 comes into contact with the contact sensing structure 130 before the stator electrodes 118A, 118B, the contact sensing structure 130 is arranged facing an end portion of the movable mass 112.

In particular, in this embodiment, the movable mass 112 comprises a main region 112A which faces the stator electrodes 118A, 118B, and a deformable region 133 which is configured to undergo an elastic deformation in response to the contact between the movable mass 112 and contact sensing structure 130.

For example, the deformable region 133 may have different dimensions with respect to the main region 112A such as to make it elastically deformable in response to the bump with the contact sensing structure 130. For example, the deformable region 133 may have a thickness, along the third axis Z, smaller than that of the main region 112A, or the deformable region 133 may have the same thickness, along the third axis Z, as the main region 112A and have a suitable in-plane geometry (layout), depending on the specific manufacturing steps used and the specific application.

The deformable region 133 faces, at rest, the contact sensing structure 130 along the third axis Z, at a distance from the contact sensing structure 130.

In detail, in this embodiment, the deformable region 133 forms an extension of the movable mass 112 along a direction parallel to the axis Y.

The deformable region 133 extends starting from one end (external wall) of the main region 112A.

The MEMS accelerometer 100 may also have a protruding portion 135 which extends from the deformable region 133 along the third axis Z towards the substrate 10 and faces (at rest) the contact sensing structure 130. In practice, in this embodiment, the protruding portion 135 acts as a contact portion between the movable mass 112 and the contact sensing structure 130.

As shown in the embodiment of Figure 5, the main region 112A of the movable mass 112 may also comprise a further protruding portion 137 facing above the contact sensing structure 130. In detail, the further protruding portion 137 extends from the main region 112A along the third axis Z towards the contact sensing structure 130.

In practice, the protruding portion 137 is arranged at a distance from the fulcrum F, along the axis Y, which is shorter than the distance of the protruding portion 135 from the fulcrum F along the axis Y. Consequently, in response to a rotation of the movable mass 112, the protruding portion 135 may come into contact with the contact sensing structure 130 before the protruding portion 137. This allows the protruding portion 137 and the contact sensing structure 130 to act as stopper region of the MEMS accelerometer 100.

The MEMS accelerometer 100 also comprises the connection means 37, 38, and 39 for the electrical connection of the movable mass 112, the stator electrodes 118A, 118B, and the contact sensing structure 130, respectively, as discussed in reference to the MEMS accelerometer 1.

In use, as shown for example in Figure 6, the MEMS accelerometer 100 has a functioning similar to the MEMS accelerometer 1 described in reference to Figures 2 and 3 and is therefore not further described in detail.

In practice, the contact sensing circuitry 46 is configured to sense a contact between the movable mass 112 and the contact sensing structure 130 and, in response, modify the bias between the movable mass 112 and the stator electrodes 118A, 118B, so as to reduce (in particular, to zero) the electrostatic force between the movable mass 112 and the stator electrodes 118A, 118B.

In this manner, even in the presence of an adhesion force between movable mass 112 and contact sensing structure 130, it is possible to make the torque T_{mec} exerted by the coupling elastic element 116 on the movable mass 112 to take the movable mass 112 back to the equilibrium position.

In practice, also the MEMS accelerometer 100 may have a high robustness against the stiction phenomenon of the movable mass 112.

In addition, also in this embodiment, the presence of the deformable region 133 contributes to further increasing the robustness of the MEMS accelerometer 100 against the stiction phenomenon, similarly to what has been discussed in reference to the deformable region 33 of the MEMS accelerometer 1.

Finally, it is clear that modifications and variations may be made to the MEMS accelerometer described and illustrated herein without thereby departing from the scope of the present invention, as defined in the attached claims.

The MEMS accelerometers 1, 100 may have a shape different from that shown and described.

For example, number and arrangement of the coupling elastic elements, stator electrodes, stopper regions, etc. may be different.

For example, with reference to the MEMS accelerometer 1 of Figure 1, the stator electrodes 18A, 18B may be coupled to an external wall of the movable mass 12. For example, the movable mass 12 may not have the through cavity 20.

For example, the stopper region 25 may be absent and the contact sensing structure 30 may act as a stopper region.

The MEMS accelerometer 1 may have other stopper regions, for example on the side facing the anchoring region 14.

For example, the movable mass 12 may have a shape different from that shown, for example not rectangular or quadrangular but with a different number of sides, or have a regular or irregular shape, depending on the specific design requirements.

For example, the stopper region 25 and the contact sensing structure 130 may be configured to come into contact with portions, surfaces, walls or faces of the movable mass 12 different from that shown and/or different from each other, depending on the specific shape of the movable mass 12.

For example, the movable mass 12 may have a plurality of openings 150, distinct from each other, which pass through the movable mass 12 throughout the thickness of the movable mass 12 along the third axis Z. In alternative, the openings 150 may be absent.

For example, the MEMS accelerometer 100 may have a structure different from the teeter-totter one, i.e. a structure wherein the movable mass 112 is coupled to the substrate 10 so as to undergo an out-of-plane movement different from a rotation (for example a translation) in response to an acceleration of the MEMS accelerometer along the out-of-plane direction (Z).

The MEMS accelerometer 100 may have a teeter-totter structure, but a shape different from what has been shown and described.

For example, the coupling elastic elements 16, 116 may be configured to cause a movement of the movable mass 12, 112 along the sensing direction S, S' in response to an acceleration along a direction transversal to the sensing direction S, S'.

For example, the MEMS accelerometers 1, 100 may be biaxial or triaxial accelerometers, i.e. configured to sense accelerations along two or more sensing directions transversal to each other.

For example, the rotor V_{ROT} and stator V_{STAT} voltages may be reversed one with the other. For example, to reduce or zero the electrostatic force between the movable mass and the stator electrodes, the stator voltage V_{STAT} may be modified in addition to or alternatively to the rotor voltage V_{ROT}.

For example, the contact sensing circuitry 46 may be configured to sense the contact between the movable mass and the contact sensing structure in a manner different from what has been described; for example, by sensing an alternating current or using other methods that do not envisage monitoring a current.

For example, stator electrodes 18A, 18B and external wall 26 may be biasable in a manner independent of each other, for example in case the movable mass 12 comprises insulating regions. For example, the rotor electrodes 21A, 21B may be formed by different structures (for example protrusions) coupled integrally to the movable mass 12.

The Applicant has verified that MEMS accelerometers may be more sensitive to stiction phenomena and electrostatic contribution with respect to other MEMS sensors; consequently, the invention has been described hereinabove with reference to MEMS accelerometers. However, the invention may refer to a MEMS sensor of a different type, for example an inertial sensor such as for example a gyroscope configured to measure a rotation of the MEMS sensor, or a non-inertial MEMS sensor to measure a different physical quantity, wherein the MEMS sensor has a movable mass suspended over a substrate and configured to undergo a movement with respect to the substrate depending on the physical quantity to be measured, and wherein the measurement of the physical quantity is based on capacitive sensing, i.e. based on sensing capacitance variations between movable mass (e.g., rotor electrodes integral therewith) and stator electrodes (integral to the substrate) by applying a voltage difference between the movable mass and the stator electrodes.

Finally, the different embodiments described above may be combined to provide further solutions.

## Claims

1. A MEMS sensor (1; 100) configured to measure a physical quantity, comprising:
a substrate (10);
a movable mass (12; 112) suspended at a distance from the substrate along a first direction (Z), the movable mass being coupled to the substrate so as to undergo a movement (M, M', M") along a sensing direction (S; S'), with respect to the substrate, as a function of the physical quantity to be measured;
a contact sensing structure (30; 130) coupled to the substrate and extending, at rest, at a first distance (gsw) from the movable mass along the sensing direction;
at least one stator electrode (18A, 18B; 118A, 118B) coupled to the substrate and configured to form with the movable mass at least one capacitor having a variable capacitance as a function of the movement of the movable mass; and
a control circuit (5),
wherein the control circuit is configured to:
induce a voltage difference between the movable mass (12; 112) and the at least one stator electrode (18A, 18B; 118A, 118B), for sensing a capacitance variation between the movable mass and the at least one stator electrode;
sense a contact between the movable mass (12; 112) and the contact sensing structure (30; 130); and
in response to sensing the contact between the movable mass and the contact sensing structure, modify the voltage difference induced between the movable mass (12; 112) and the at least one stator electrode (18A, 18B; 118A, 118B), so as to reduce an electrostatic force exerted by the at least one stator electrode on the movable mass.

2. The MEMS sensor according to claim 1, wherein the control circuit is configured to modify the voltage difference so as to zero the electrostatic force exerted by the at least one stator electrode on the movable mass.

3. The MEMS sensor according to claim 1 or 2, wherein the control circuit is configured to modify the voltage difference between the movable mass and the at least one stator electrode for a time interval greater than 5 ms, in particular comprised between 5 ms and 30 ms.

4. The MEMS sensor according to any of the preceding claims, wherein the control circuit (5), to induce a voltage difference between the movable mass (12; 112) and the at least one stator electrode (18A, 18B; 118A, 118B), is configured to apply a rotor voltage (V_{ROT}) to the movable mass and a stator voltage (V_{STAT}), different from the rotor voltage, to the at least one stator electrode.

5. The MEMS sensor according to the preceding claim, wherein one of the rotor voltage and the stator voltage is a DC voltage having a first value (V_{cm}) and the other of the rotor voltage and the stator voltage is a varying voltage.

6. The MEMS sensor according to any of the preceding claims, wherein the control circuit (5), for sensing the contact between the movable mass (12; 112) and the contact sensing structure (30), is configured to apply a voltage difference between the movable mass and the contact sensing structure and monitor a contact current (I_{C}) between the movable mass and the contact sensing structure.

7. The MEMS sensor according to any of the preceding claims, wherein the contact sensing structure (30; 130) extends, at least in part, facing the movable mass (12; 112) parallel to the sensing direction (S; S').

8. The MEMS sensor according to any of the preceding claims, wherein at least one of the contact sensing structure (30) and the movable mass (112) comprises a deformable region (33; 133) configured to undergo an elastic deformation along the sensing direction (S; S'), in response to the contact of the movable mass with the contact sensing structure.

9. The MEMS sensor according to any of the preceding claims, configured so that the movable mass (12; 112), in response to a movement along the sensing direction (S; S'), comes into contact with the contact sensing structure (30; 130) prior that with the at least one stator electrode, for example the at least one stator electrode (18A, 18B) may extend, at rest, at a second distance (gₑₗ) from the movable mass along the sensing direction that is greater than the first distance (gsw) .

10. The MEMS sensor according to any of the preceding claims, further comprising a stopper region (25; 130, 137) configured to determine a maximum movement of the movable mass (12; 112) along the sensing direction (S; S'), the maximum movement being smaller than the movement along the sensing direction which would put the movable mass into contact with the at least one stator electrode.

11. The MEMS sensor according to the preceding claim, configured so that the movable mass (12; 112) comes into contact with the contact sensing structure (30; 130) in response to a movement along the sensing direction (S; S') which is smaller than the maximum movement.

12. The MEMS sensor according to any of the preceding claims, wherein the MEMS sensor is an inertial sensor and wherein the quantity to be measured is an acceleration or a rotation of the MEMS sensor, in particular wherein the MEMS sensor is a MEMS accelerometer and the physical quantity to be measured is an acceleration of the MEMS sensor.

13. The MEMS sensor according to the preceding claim, wherein the MEMS sensor is an in-plane MEMS accelerometer (1) configured to sense an acceleration along a second direction (Y) transversal to the first direction (Z) or an out-of-plane MEMS accelerometer (100) configured to sense an acceleration along the first direction (Z).

14. A method for controlling a MEMS sensor configured to measure a physical quantity, the MEMS sensor comprising:
a substrate (10);
a movable mass (12; 112) suspended at a distance from the substrate along a first direction (Z), wherein the movable mass is coupled to the substrate so as to undergo a movement (M, M', M") along a sensing direction (S; S'), with respect to the substrate, as a function of the physical quantity to be measured;
a contact sensing structure (30; 130) coupled to the substrate and extending, at rest, at a first distance (gsw) from the movable mass along the sensing direction; and
at least one stator electrode (18A, 18B; 118A, 118B) coupled to the substrate and configured to form with the movable mass at least one capacitor having a capacitance variable as a function of the movement of the movable mass;
the method comprising, by a control circuit of the MEMS sensor:
inducing a voltage difference between the movable mass (12; 112) and the at least one stator electrode (18A, 18B; 118A, 118B), for sensing a capacitance variation between the movable mass and the at least one stator electrode;
sensing a contact between the movable mass (12; 112) and the contact sensing structure (30; 130); and
in response to sensing the contact between the movable mass and the contact sensing structure, modifying the voltage difference between the movable mass (12; 112) and the at least one stator electrode (18A, 18B; 118A, 118B), so as to reduce an electrostatic force exerted by the at least one stator electrode on the movable mass.
